# EUROPEAN PATENT SPECIFICATION

(11) **EP 2 423 350 B1**
(45) Date of publication and mention of the grant of the patent: **31.07.2013**
(21) Application number: 10174387.0
(22) Date of filing: 27.08.2010
(51) Int. Cl.: C23C 14/50, C03C 17/00

(54) **Carrier for a substrate and a method for assembling the same**
Substratträger und Aufbauverfahren dafür
Support pour substrat et son procédé d'assemblage

(43) Date of publication of application: 29.02.2012
(73) Proprietor: Applied Materials, Inc., Santa Clara, CA 95054 (US)
(72) Inventor: Brüning, Andre, 63811 Stockstadt (DE); Heimel, Oliver, 34590 Wabern (DE); Hinterschuster, Reiner, 63546 Hammersbach (DE); Wolf, Hans Georg, 63526 Erlensee (DE)
(74) Representative: Neuburger, Benedikt Maria

(56) References cited:
- US-A- 2 286 819
- US-A- 4 180 347
- US-A1- 2007 069 351

## Description

### Technical field of the invention

The present invention is relates to carriers for substrates and to methods for assembling the same in the field of vacuum deposition of thin films. In particular, the present invention is directed to a carrier for a substrate, wherein the carrier includes two frames.

### Background of the invention

Thin film deposition technology plays a crucial role for production of numerous devices. In complex deposition lines it is desirable to achieve a maximum operation time, i.e. to reduce maintenance and loading times to a minimum. In this way, the efficiency of the deposition lines is increased what is of importance for industrial success of such systems.

DE 10 2005 045 718 B1 discloses a carrier for a substrate wherein at least a part of the carrier consists of a material with larger thermal expansion coefficient than the thermal expansion coefficient of the substrate, characterized in that a predetermined region of the carrier has a bridge which is centrally attached, which has a thermal expansion coefficient smaller than the region it is attached to.

DE 10 2005 045 717 B3 discloses a carrier for a substrate having two horizontal and two vertical plates.

EP 1 840 242 A1 shows an apparatus for transporting substrates through vacuum chambers, in particular coating facilities with a substrate carrier, on or at which the substrate can be attached, wherein the substrate carrier includes at least one guard rail, which extends along at least one side of the substrate carrier, and wherein the guard rail is bore spaced apart from the substrate carrier by one or several spaced apart bearings.

U.S. Publ. No. 2007/0069351 A1 refers to a carrier for a substrate, wherein at least parts of the carrier are comprised of a material with a coefficient of thermal expansion which is higher than the coefficient of thermal expansion of the substrate.

### Summary of the invention

The invention relates to a carrier for a substrate to be coated in a vacuum chamber as set forth in claim 1 and a method for assembling a carrier a s set forth in claim 11. Preferred embodiments are described in the dependent claims.

In one general aspect, the carrier for a substrate to be coated in a vacuum chamber comprises a first frame comprising two vertical sections and two horizontal sections being dimensioned to surround the substrate, a second frame dimensioned to define an area of the substrate to be coated, and to cover at least a first part of the first frame to prevent the first part of the first frame from being coated when the second frame is mounted to the first frame, and wherein the second frame is detachably mounted to the first frame. In deposition processes, in particular in deposition processes including a moving substrate, any frame or other holder means may be exposed to a deposition source and coated by a deposition material forming a layer of coated material on the frame or other holder means. After a predetermined number of deposition runs, the coated material on the frame or holder may detach, hereby forming particles that migrate in a uncontrolled manner, e.g. onto the substrate or other parts of the deposition facility. These particles may have detrimental effects on the processed substrates, in cases may even destroy them. Therefore, regular cleaning of the frame or holder is required to remove the deposited material before a critical condition, e.g., a thickness of a layer of the deposited material, that results in possible detachment, is reached. Naturally, the disassembly of the frame and the cleaning causes down-time of the deposition device. The carrier of the present disclosure comprising two frames may secure that the second frame can be readily demounted and cleaned while the first frame is partially or totally protected from being coated by the second frame. Thus, the first frame may require to be cleaned less often than the second frame. In some cases, the first frame may not be substantially coated with the result that no deposited material has to be removed at any time. Such frames may be continuously used in a deposition device without intermittent cleaning periods. Alternatively or additionally, this may facilitate that the first frame may be permanently mounted inside a deposition device as it may not be necessary to demount and clean it regularly. This may further reduce the complexity of the deposition device.

The term "vacuum" in the context of "vacuum chamber" refers to a situation wherein a pressure inside an enclosure (e.g. a chamber) is adjusted to have any predetermined pressure below atmospheric pressure, in preferred aspects the pressure may be lower than 300 mbar, lower than 10⁻³ mbar (high vacuum), or lower than 10⁻⁷ mbar (ultra high vacuum).

In other aspects, the second frame is dimensioned to prevent an edge area of the substrate from being coated.

In other aspects, the second frame comprises two vertical sections and two horizontal sections. In preferred aspects, the second frame may be assembled from four parts including the vertical and horizontal sections. This may be advantageous as frames assembled from different parts are believed to be more cost efficient in production than integral frames. The frames may have any predetermined size. Alternatively, the frames may be formed integrally from a single piece of a material, particularly if they are smaller than a predetermined size. As soon as the size of the frame exceeds a predetermined limit, it may be more efficient to assemble the second frame from two vertical sections and two horizontal sections. This may have the advantage that single sections can be exchanged quickly in case of a defect on said sections.

In other aspects of the carrier, the vertical sections of the first frame are of a different material than the horizontal sections of the first frame; and/or the vertical sections of the second frame are of a different material than the horizontal sections of the second frame. By having different materials in the different sections a compromise between different performance parameters of the frames can be achieved. It may be desirable, e.g., to have a carrier with high structural integrity and on the other hand employ a cheap material. In such a situation, different sections can include (e.g. be made of) different materials with predetermined properties. In such manner, different design goals can be met with respect to predetermined parameters. For instance, the vertical sections of the first frame may comprise a cheap and soft material, wherein the second frame may comprise vertical sections including a stabile and expensive material. This combination may ensure that price and mechanical properties of the carrier meet predetermined requirements. In an alternative, all sections of the first and/or the second frame may comprise different materials.

In other aspects of the carrier, the first frame comprises aluminum and/or the vertical sections of the first frame comprise titanium.

In other aspects of the carrier, the second frame comprises titanium and/or the vertical sections of the second frame comprise aluminum. The combination of titanium and aluminum may be preferred as aluminum is a light, comparably inexpensive metal wherein titanium may have favorable thermal expansion properties (roughly, the thermal expansion coefficient of aluminum is three times higher than the thermal expansion coefficient of titanium). Both factors may be of increasing importance for large frames supporting large substrates (e.g. larger than 2x1 m²) where a satisfying compromise between mechanical integrity and price may be more difficult to find.

In a preferred embodiment, the vertical sections of the first frame include titanium and the horizontal sections of the first frame include aluminum and the vertical sections of the second frame include aluminum and the horizontal sections of the second frame include titanium. All sections can also be made from aluminum and titanium, respectively. This combination may provide a carrier wherein both frames comprise complementary configurations with respect to the chosen material. Therefore, when the two frames are joined, a substrate is enclosed without a gap by titanium sections. This may be advantageous in view of the different thermal expansion coefficients of aluminum and titanium. Evidently, this complementary configuration may also have said advantageous effects for other material pairs.

In other aspects, the second frame comprises stopper sections to confine the substrate in a horizontal direction. This may prevent the substrate from moving in a horizontal direction which may cause displacement or even damage of the substrate. As in some aspects the horizontal sections of the second frame comprises, or consist of, titanium which may have a low similar thermal expansion coefficient as typical substrate materials, e.g. glass, the stopper section can be attached to the second frame. When the second frame and the substrate are heated, the substrate will nevertheless remain horizontally secured by the stoppers. In carriers where the horizontal sections comprise other materials, additional measures may have to be employed. Therefore, the carriers allow for a simple and efficient design with respect to the stoppers.

In other aspects, the stopper sections are arranged at positions of the second frame suitable such that the substrate can be confined to a horizontal position at elevated temperature, especially at a temperature close to a processing temperature of the vacuum chamber, ensuring that vertical edges of the substrate are covered by the second frame. As temperatures of the processes may be high and a material the frames comprise may undergo a substantial change in geometry when being heated, it is advantageous to introduce the stopper sections in order to maintain a predetermined configuration of the substrate inside the carrier.

In other aspects, the horizontal sections of the second frame are fixed to the first frame at or close to the middle of the horizontal extent of the horizontal sections of the first frame such that the a thermal expansion of the second frame when heated is substantially symmetrical in horizontal direction with respect to the first frame. In such manner, a well-defined expansion of the two frames may be guaranteed. In particular, if the first frame includes horizontal sections comprising aluminum and vertical sections comprising titanium and vice versa for the second frame, a substantial difference in thermal expansion of both frames in horizontal direction may occur. By fixing the horizontal sections in a central position, this difference may evolve symmetrical on both sides of the horizontal sections. This way, no unwanted asymmetries in expansion resulting in an asymmetrical or uncontrolled exposition of the substrate and the frame may occur. As in some embodiments the second frame comprises stoppers in order to confine the substrate horizontally, in a worst case scenario the thermal expansion of the frames could result in an expansion that compromises the carrier's capability to affix the substrate. On the other hand, in systems with well defined expansion properties the precision and reproducibility of the fabrication process may be higher and the carrier may be designed with less material as design margins, e.g., to secure a coverage of the substrate's edges, may be reduced.

In other aspects, the vertical sections of the second frame are fixed to the first frame at or close to the middle of the vertical extent of the vertical sections of the first frame such that the a thermal expansion of the second frame when heated is substantially symmetrical in vertical direction with respect to the first frame. As in a preferred aspect, the first frame includes horizontal sections comprising aluminum and vertical sections comprising titanium and vice versa for the second frame, a substantial difference in thermal expansion of both frames in vertical may occur. A fixation close to the middle of the vertical sections thus has the same advantages as explained above in connection with the fixation of the horizontal sections.

In other aspects, the second frame is detachably mounted to the first frame using keyhole bolt joints. This feature may allow a quick mounting of the second frame onto the first frame.

In other aspects, the second frame comprises bolts at a side facing the first frame, the bolts designed to engage with corresponding keyhole openings in the first frame.

In other aspects, the keyholes are designed to allow movement of the corresponding bolts in an engaged position. This feature is advantageous in particular in systems where the frames, or sections of the frames undergo substantial thermal expansion in the temperature ranges occurring during a deposition process.

In other aspects, the keyholes are designed such that the movement of the corresponding bolts in the engaged position is more limited in a first spatial direction, especially in the vertical direction, than in a second spatial direction, especially in the horizontal direction, the first and second spatial directions are both in a plane substantially parallel to the first frame.

In other aspects, the keyholes are designed to take a relative movement of the first frame with respect to the second frame caused by thermal expansion when being heated from a first temperature to a second temperature into account, preferably the second temperature is a processing temperature of the vacuum chamber.

In other aspects, the keyhole bolt joints are designed, preferably by keyholes formed with a chamfer, to pull the second frame towards the first frame when mounting the second frame to the first frame. In such a configuration, the second frame may be merely suspended to the first frame via appropriately positioned keyholes and bolts. This allows a very effective mounting and demounting of the first frame, as the processes may be carried out solely by moving the first frame without requiring further tools. This further reduces the down-time of the deposition line.

In other aspects, the first frame may be mounted to the second frame by suspension. The first and second frames may comprise corresponding means that facilitate the suspension.

The keyholes, in particular when additionally being configured to allow a relative movement of the first frame with respect to the second frame in a first direction and limit it in a second direction, may be of particular use if the frames comprise sections including different materials. In preferred aspects, different materials having different thermal expansion coefficients, e.g. titanium and aluminum may be employed in the vertical and horizontal sections of the first and/or second frame. Then, a configuration with keyholes each allowing a relative movement of the first frame with respect to the second frame in a first direction and limit it in a second direction may have a particularly advantageous effect in securing a well-defined expansion behavior of the carrier.

In other aspects, the carrier further comprises clamping means supported by the first frame and suitable to fix the substrate by clamping against the second frame. In preferred aspects, these clamping means are arranged at a surface of the first frame facing away from the deposition source and engage with a surface of the substrate facing away from the deposition source. Thus, any diminishment of the area of the substrate to which a coating may be applied on by the deposition facility may be avoided. This enhances the yield of the deposition facility as waste of substrate area that is potentially available to deposit films thereon is avoided.

In other aspects, the horizontal sections of the first frame comprise horizontal slots to reduce thermal deformation of outer parts of the horizontal sections. In some deposition devices, heating elements may be arranged collinear with the vertical sections of the first and second frames and extending substantially parallel to a vertical extension of a substrate. This may result in a stronger heating of inner parts of the horizontal sections and a weaker heating of outer parts. The vertical sections, particularly if the substrate is moved in a horizontal direction, may be heated more homogeneously than the horizontal sections. Thus, it may be advantageous to reduce thermal coupling between said inner and outer parts of the horizontal sections. In addition, the substrate may be substantially heated during the deposition process. Thus, any parts of the first frame in direct contact with the substrate may itself exhibit more heating due to the thermal contact with the hot substrate. As the horizontal sections of the first frame may be thermally conductive it may be advantageous to reduce thermal coupling between said parts in thermal contact with the substrate and the outer parts of the horizontal sections.

In other aspects, a surface of the second frame which is exposed to coating in a vacuum chamber comprises surface patterned sections, especially waffle-patterned sections, especially wherein only the vertical sections of the second frame comprise the surface patterned sections. A patterned surface may increase the surface of the sections and may also increase the amount of coating material that can be deposited onto the section before adverse detachment effects occur. This way, the number of deposition runs for the first frame without cleaning may be increased.

Other aspects include a method for assembling a carrier, preferably any of the carriers described above, for a substrate to be coated in a vacuum chamber comprising the steps of providing a first frame, providing a second frame, removably mounting the second frame to the first frame prior to mounting a substrate to the carrier, wherein the second frame is dimensioned to define an area of the substrate to be coated, and to cover at least a first part of the first frame to prevent the first part of the first frame from being coated when the second frame is mounted to the first frame.

Further aspects of the methods include that the second frame is dimensioned to prevent an edge area of the substrate from being coated.

Further aspects of the methods include that mounting the second frame to the first frame includes using keyhole bolt joints.

Further aspects of the methods include, wherein the keyhole bolt joints are designed, preferably using keyholes formed with a chamfer, to pull the second frame towards the first frame when mounting the second frame to the first frame.

Further aspects of the methods further comprise that:
preassembling the second frame before the second frame is mounted to the first frame, wherein preassembling the second frame comprises joining vertical sections and horizontal sections of the second frame. In other cases, in particular if the frames exceed a predetermined size, the horizontal and vertical sections of the second frame may be mounted separately to the first frame.

Further aspects of the methods further comprise that:
fixing the second frame to the first frame, especially by using one or more screws.

Further aspects of the methods include that the second frame is fixed to the first frame such that a relative movement of the first frame with respect to the second frame caused by thermal expansion when being heated from a first temperature to a second temperature. Preferably the second temperature is a processing temperature of the vacuum chamber, is controlled by the fixing of the second frame to the first frame.

### Short description of the Figures

- Fig. 1: shows a schematic drawing of an embodiment of the present disclosure.
- Fig 2: shows a schematic drawing of an embodiment in a front and two side views
- Fig. 3: shows a schematic drawing of an embodiment with the two frames detached.
- Fig. 4: illustrates thermal expansion of a carrier.
- Fig 5: shows a schematic drawing of keyholes
- Fig 6: shows a schematic cross-sectional detail of an embodiment.
- Fig. 7: is a flow chart of an embodiment of the methods of the present disclosure.

### Detailed description

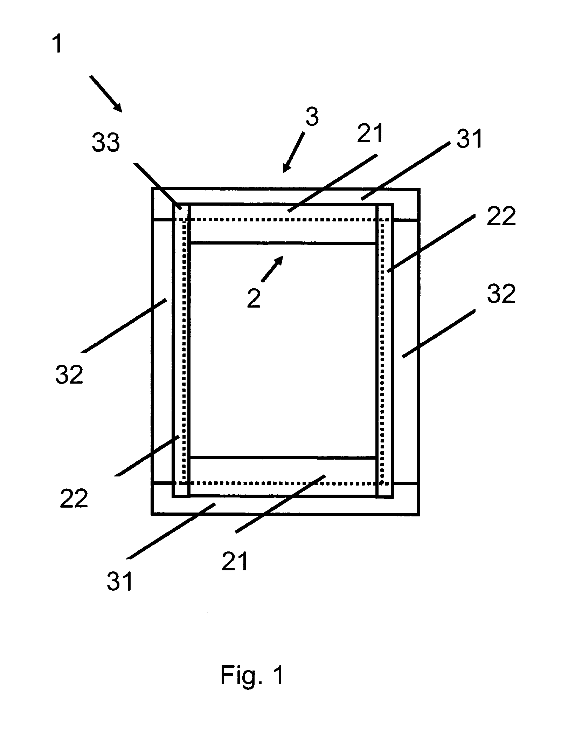

In Fig. 1 a carrier 1 is shown. The carrier 1 for a substrate to be coated in a vacuum chamber comprises a first frame 3 comprising two vertical sections 32 and two horizontal sections 31 being dimensioned to surround the substrate, a second frame 2 dimensioned to define an area of the substrate to be coated, and to cover at least a first part 33 of the first frame 3 to prevent the first part 33 of the first frame 3 from being coated when the second frame 2 is mounted to the first frame 3, and wherein the second frame 2 is detachably mounted to the first frame 3.

The terms horizontal and vertical sections refer to a configuration in a vertical deposition device. In such a configuration, the deposition device may be configured to house and process the substrate in a substantially vertical position. This means that the extended surfaces of the substrate are substantially coplanar to the direction of the force of gravity. In such a device the carrier and herewith the first and second frames will have substantially the same orientation as the substrate. Therefore, the elongated sections forming each frame can be classified as vertical and horizontal sections, wherein "vertical" refers to the sections located on the parts of the frame extending substantially parallel to the direction of the force of gravity and "horizontally" refers to sections located on the parts of the frame extending substantially orthogonal to the direction of the force of gravity. However, all carriers and methods for assembling carriers can be equally applied in deposition devices housing and processing substrates in a substantially horizontal manner and also in all intermediate configurations between horizontal and vertical deposition devices. In a horizontal deposition device where all parts of the frames extend substantially in a horizontal plane one pair of sides of the frames may be labeled "horizontal" and the other pair "vertical".

The term "detachably mounted" includes all situations where the first frame is attached to the second frame by any releasable means. In some embodiments, this may include attachment devices that facilitate manual or tool assisted mounting and release of the first frame from the second frame, e.g. by means of screws, clamps or clips. The term "detachably mounted" is, however, not limited to these embodiments.

In preferred embodiments, the first 3 and second 2 frames have a substantially rectangular outer shape. Furthermore, the second frame 2 and/or the first frame 3 can define an open inner area. The first frame 3 may also include a closed inner area so that no opening is formed. A rectangular frame is usually formed from four extended sections. The sections can have a predetermined cross-section and extend in a predetermined direction. In a vertical deposition device, e.g. a device housing and processing a substrate in a substantially vertical fashion, two of the sections have their direction of extension in a substantially vertical direction and the remaining two in a horizontal direction. In Fig. 1, the sections 21, 22, 31, 32 have a rectangular cross-section but they can have any other predetermined cross section. The width and height of the sections 21, 22, 31, 32 can be chosen to meet predetermined criteria with respect to mechanical or thermal properties or other design criteria. Even though in Fig. 1 the sections 21, 22, 31, 32 are drawn as assembled parts, the frames can be also formed integrally. In such cases, the sections 21, 22, 31, 32 may be understood purely geometrical. In other aspects, the sections 21, 22, 31, 32 refer to separate parts assembled releasebly or permanently. The carrier 1 can be employed for any substrate in any deposition process. However, in preferred aspects of the present invention the deposition process is a sputtering process or a physical vapor deposition process. In such deposition processes, the substrate temperatures and the substrate carrier temperatures may be more than 100° C or considerably higher and therefore the frame geometries and mounting means presented in this application may be advantageous. In preferred aspects the substrates are large substrates (e.g. Generation 8, i.e. 1870x2200 mm, or larger), e.g. for display or solar cell production.

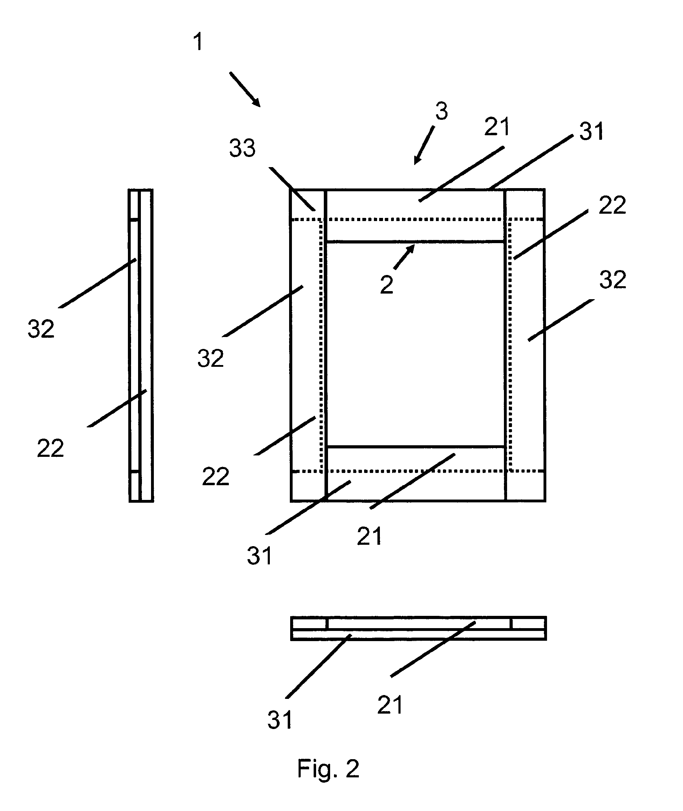

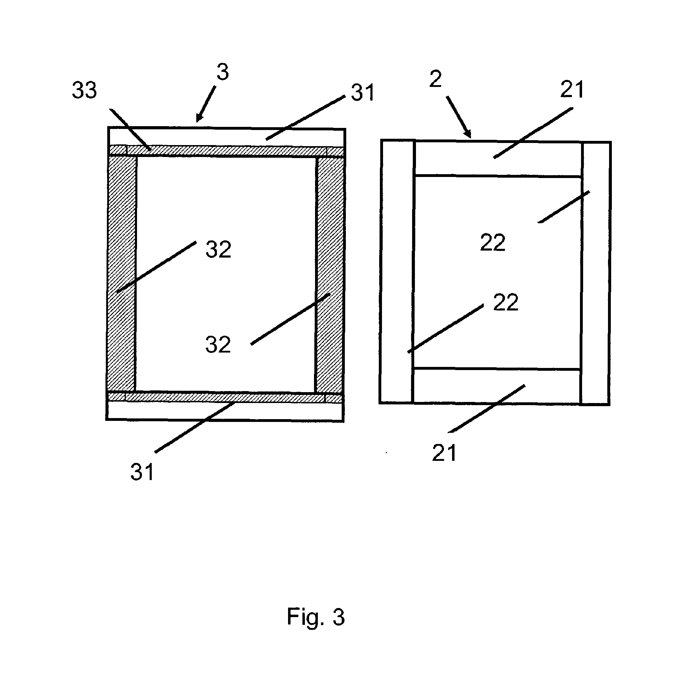

In Fig. 2, a further carrier 1 is depicted. In Fig. 2, both, the first 3 and the second 2 frames have two vertical 22, 32 and two horizontal 21, 31 sections that form the respective frame 2, 3. In Fig. 2, the second frame 2 covers the complete upper surface 33 of the first frame 3. In such manner, no material emitted from a deposition source located above the carrier 1 may be deposited onto the first frame 3. In addition, the vertical 22, 32 and the horizontal 21, 31 sections of the first 3 and the second 2 frame may have any suitable form. In Fig. 2 the horizontal 21 and verticals 22 sections of the second frame 2 are substantially bar shaped and the vertical sections 22 extend substantially from one end of the second frame 2 to the other in vertical direction. The first frame 3 has also bar-shaped sections 31, 32 but here the horizontal sections 31 extend from one end of the first frame 3 to the other in horizontal direction. In Fig. 2, the horizontal 21, 31 and vertical 22, 32 sections are substantially butt joined. In other aspects, the sections 21, 22, 31, 32 can also be miter joined. Fig. 3 also depicts side views of the to frames 2, 3 in a mounted configuration. Even though the frames are depicted in direct contact, the frames 2, 3 may also be arranged in a predetermined distance in a direction orthogonal to the planes including the first 3 or second 2 frame.

In Fig. 3, a further carrier in a demounted state is shown. Though the mounting means are not shown in Fig. 3, any suitable connector can be employed. Fig. 3 depicts a situation where the first frame 3 is partially covered by the second frame 2 and herewith prevents the covered parts 33 (lined area) of the first frame 3 from being covered with deposition material. However, in other carriers the second frame 2 may cover the complete surface of the first frame 3. As shown in Fig. 3, the second frame 2 may cover a part of the first frame 3 extending from an inner edge of the vertical sections 32 of the first frame 3 in horizontal direction to an outer edge of the verticals sections 32 of the first frame 3 and extending from an inner edge of the horizontal sections 31 of the first frame 3 in vertical direction a predetermined length smaller than an extension of the horizontal sections 31 of the first frame 3 in vertical direction. The parts of the first frame 3 not covered by the second frame 2 may be covered by one or more additional stationary baffles. Evidently, the choice which parts of the first frame 3 may be covered with the second frame 2 depend on the details of the deposition device and particularly the deposition sources. In some situations, parts of the first frame 3, e.g. an outer section, may not be exposed to the deposition source in any case. In such situations, it may be sufficient to cover an inner part of the first frame 3 with the second frame 2. In other aspects, there may be an asymmetry with respect to the exposition of horizontal 31 and vertical 32 sections of the first frame 3, e.g. an exposition extending more outward in horizontal or vertical direction requiring broader sections of the second frame 2 in said direction. In deposition devices with moving substrates a deposition source may extend substantially along the complete extension of the substrate in a direction perpendicular to a travel direction of the substrate. Then, a part of the first frame 3 extending in the direction of travel from an inner edge to an outer edge of the horizontal or vertical sections of the first frame 3 and coextending with the length of the substrate in a direction perpendicular to the travel direction may be temporally exposed to the deposition source. However, the deposition profile of a deposition device is usually well known so there is no difficulty in laying out the frames 2, 3. Thus, the other features, in particular the fastening means for the substrate and the frames 2, 3, disclosed in the application, may be employed for different geometries of the frames 2, 3.

The choice of the material for the frames is also a question of design that has to be answered for every specific substrate size and deposition type. However, there are preferential configurations and material choices. Usually, the first 3 and second 2 frames will comprise, or consist of, a metal. Preferred metals are metals comprising iron and iron alloys, such as stainless steel, aluminum or aluminum alloys or titanium or titanium alloys.

The materials of the vertical sections 32 and horizontal sections 31 of the first frame 3 can include, or consist of, different materials. It may be prohibitive to manufacture the entire first frame from a first material due to price, weight or other restrictions. In such cases the vertical sections 32 can include or consist of the first material, wherein the horizontal sections 31 include or consist of a second material. In preferred frames the first material is titanium and/or the second material is aluminum.

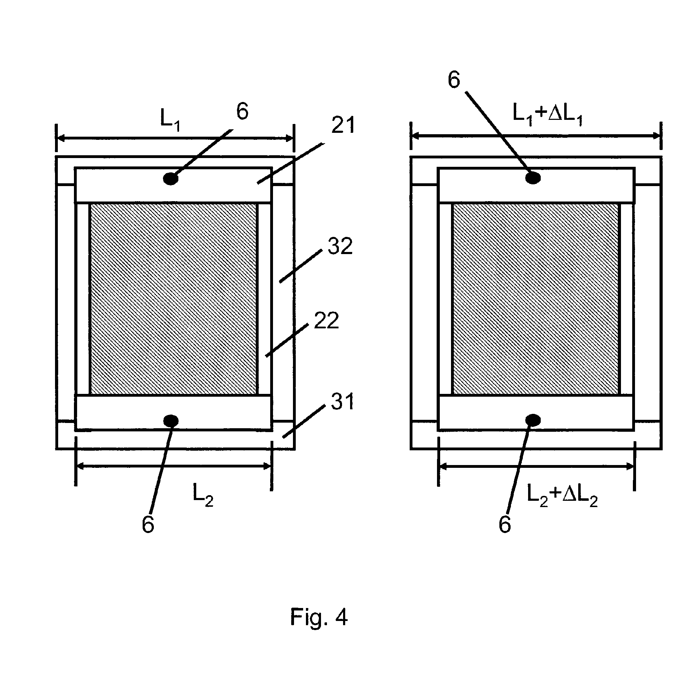

In Fig. 4 a preferred aspect of the carriers is shown. The horizontal sections 31 of the first frame 3 and the horizontal sections 21 of the second frame 2 are fixed by appropriate fixation means 6 in a position about the middle of each section in horizontal direction. Under a first mounting temperature the horizontal sections 31 of the first frame 3 may have a first length L₁ and the horizontal sections 21 of the second frame 2 may have a second length L₂. If the carrier is subsequently heated, e.g. from the first mounting temperature to a second processing temperature, it is believed that the horizontal sections of the first and second frames expand to a length of L₁+ΔL₁ and L₂+ΔL₂, respectively. As the movement is only restricted by fixation means 6, the expansion is believed to evolve in a symmetrical fashion on a left and right side of the fixation means. In case the thermal expansion coefficients of the horizontal sections of the first and second frames 21, 31 are different, this fixation configuration nevertheless allows the frames to expand in a controlled manner. The horizontal sections 21, 31 may comprise different materials, e.g. metals with different thermal expansion coefficients as aluminum and titanium. The vertical sections 22, 32 may also exhibit a predetermined expansion (not shown in Fig. 4,) if the carrier is heated, e.g. from the first mounting temperature to a second processing temperature.

In addition or alternatively, fixation means can be employed along a vertical direction of the vertical sections 22, 32 of the first and second frame 2, 3. Preferably, this fixation means are placed in the upper third of the vertical sections 22, 32. Said fixation means can also be combined with other devices for mounting the second frame onto the first, in particular with the keyhole joints described in more detail below.

The first frame 3 and second frame 2 can be assembled by using different mounting schemes. In some cases the second frame 2 may be firmly mounted on the first frame 3 at predetermined positions by connectors, such as screws or bolts, or the second frame 2 may be clipped or clamped to the first frame 3 by suitable means. For instance, a predetermined number of screws can be positioned circumferentially about the first frame 3 and second frame 2 to firmly mount the second frame 2 onto the first frame 3. However, particularly in cases where the carrier is used under varying process temperatures (e.g. a first temperature when the carrier is assembled and a second temperature during deposition), other mounting schemes may be advantageous. This is even more the case as preferred carriers employ different materials, e.g. aluminum and titanium, with different thermal expansion coefficients in different sections of the first and second frames. In such carriers, the relative position of a first point located on the first frame and a second point located on the second frame may alter when the assembled carrier is heated. In an exemplary carrier the horizontal sections of the first frame may comprise, or consist of, aluminum and the horizontal sections of the second frame may comprise, or consist of, titanium. Thus, the horizontal sections of the first frame may have a larger thermal expansion. Therefore, the first and second frames are preferably equipped with suitable mounts that may have a play in directions so that the differences in thermal expansion of the first and second frame can be tolerated. Some carriers may be provided with fixation means located in the region of the center of the horizontal extent of the horizontal sections and/or close to the center of the vertical extent of the verticals sections. This configuration may secure that relative thermal movement of the second frame with respect to the first frame when heated is substantially symmetrical in a horizontal and/or vertical direction. In general, the frames may expand during heating herewith increasing the area of the substrate exposed to the deposition source. By having a symmetrical movement of the second frame with respect to the first frame also the exposed area on the substrate may be symmetrical in the horizontal and/or vertical direction.

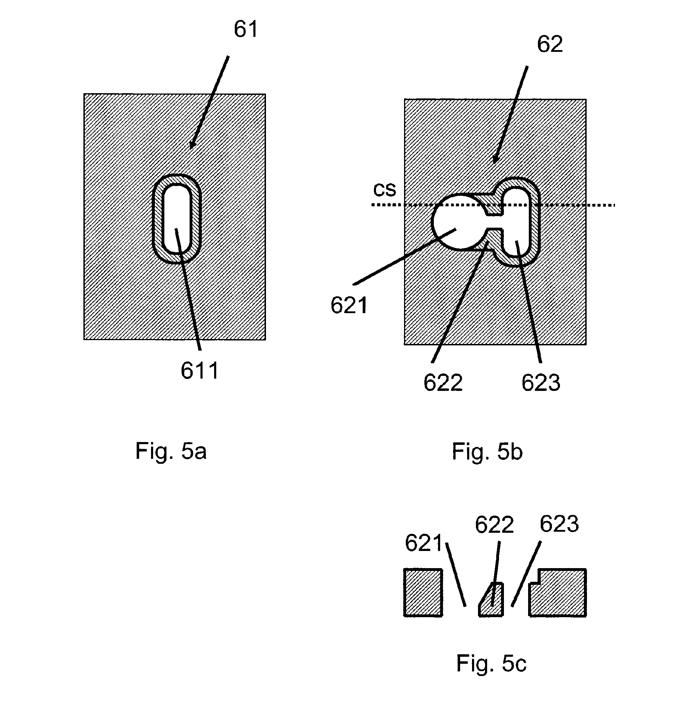

Fig. 5a depicts an exemplary recession 61 configured to mount the second frame to the first frame in combination with a corresponding screw or bolt (not shown). For instance, the recession 61 could be positioned at a circumferential position about the first frame and the second frame could comprise a bolt or screw hole at a corresponding position. As can be seen from Fig. 5a, recession 61 has an elongated aperture 611. This allows a movement of the first and second frame in a first direction wherein it limits the movement in a second direction. Usually, the first direction may be a direction in which a particular large relative movement due to thermal expansion of different sections of the first and second frames may occur. Therefore, the length of the elongated aperture 611 may be chosen with respect to the expected relative movement due to thermal expansion for predetermined process temperatures.

Fig. 5b shows a detailed view of an alternative mounting recession in form of a keyhole 62 for mounting the second frame to the first frame. In such cases, the carrier may also be equipped with corresponding mounting bolts or screws. For instance, the bolts may be arranged circumferential about the second frame and the keyholes at corresponding positions at the first frame. The keyholes also have an elongated section 623 that allows the movement of the second frame with respect to the first frame in a first direction and limits the movement in an orthogonal second direction. The two directions may be aligned parallel to the horizontal and vertical sections, or vice versa. It may be also advantageous to allow a movement in a direction substantially in the plane of the first and second plane forming an angle with respect to the horizontal or vertical directions. Furthermore, the keyhole 62 of Fig 5b comprises an insertion section 621 where the corresponding bolts can be inserted to during engagement of the bolts and the keyholes 62. Then, the engaged bolt can be moved into the elongated section 623 of the keyhole 62. In preferred embodiments the keyhole 62 additionally comprises a chamfer 622 for automatically pulling the second frame towards the first frame when the bolts are inserted into the keyholes. In this manner, the assembly of the first and second frames may be simple and quick. In Fig. 5c, the keyhole of Fig. 5b is depicted in a cross-sectional view (the location cross-section plane is shown in Fig. 5b as dashed line cs). Fig. 5c shows that the chamfer 622 is chamfered so that a wall thickness increases from a first predetermined thickness adjacent to the insertion section 621 to a second predetermined thickness adjacent to the elongated section 623. This may facilitate that a bolt inserted in the insertion section may be pulled along the chamfer 622 in order to engage with the elongated section 623. As a result, the second frame may be pulled towards the first frame. In order to secure the frames against dropping, further fastening means, e.g. screws, may be provided at additional locations about the circumference of the first and second frames. In particular, the fixation means close to the middle of the horizontal extent of the horizontal sections of the first frame and/or close to the middle of the vertical extent of the vertical sections of the first frame can be combined with the keyholes and bolts. In other carriers, the keyholes and bolts are positioned close to the middle of the horizontal extent of the horizontal sections of the first frame and/or close to the middle of the vertical extent of the vertical sections of the first frame.

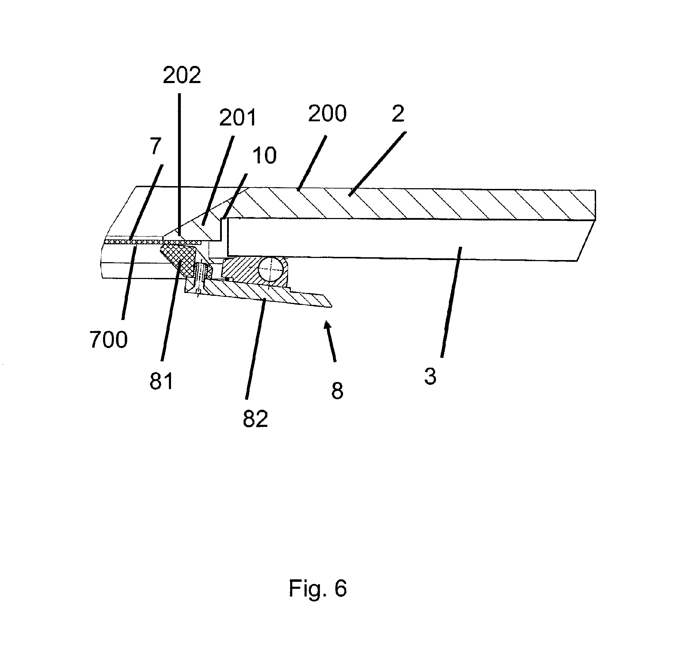

The substrate is affixed to the carrier by employing a clamp system. In Fig. 6, the clamp system 8 is mounted onto the first frame 3 and fixates the substrate 7 against a resting portion 202 of the second frame 2. The substrate 7 could also rest on the first frame 3. In such a carrier, the second frame 2 may be removed while the substrate 7 is still held in place by the clamp system 8 and the first frame 3. In the carrier of Fig. 4, the combined first and second frames 2, 3 and the clamp system 8 secure that the substrate is affixed. The clamp system 8 can be released by pushing a handle 82 and may have a retention mechanism that presses a distal portion of the clamp system against the substrate 7 to be affixed. The clamp system may also be secured in a predetermined position by a locking mechanism. Said distal portion may comprise a suitable contact portion 81 that may impart pressing force onto the substrate 7 without damaging it, e.g. by scratching. Furthermore, the contact portion 81 may be configured to have a coefficient of friction suitable to allow a movement of a contact patch to the substrate 7, as the geometry may alter due to thermal expansion of the first 3 and second 2 frames. In addition the clamp system 8 may be movable or removable in order to facilitate a facile removal of the substrate 7. Having a clamp system 8 acting on a surface of the substrate facing away from the deposition source 700 may have the advantage that no area of the substrate 7 is shaded by the clamp system 8 and therewith may not be available to be coated. Evidently, this may enlarge the area of a substrate 7 usable for device fabrication. Moreover, in a configuration as shown in Fig. 6, the clamp system 8 is covered by the second frame 2 and the substrate 7 during deposition and therefore may not be coated. This is also of advantage as such clamp system 8 may not require frequent cleaning. In other cases, it may also be required to attach a clamp system 8 at the second frame 2 and/or on a surface 200 facing the deposition source.

Even though the exemplary carrier of Fig. 6 shows a fixation system for the substrate employing a clamp system 8, any other suitable means for fixation of the substrate 7 can also be employed in the carriers. In other aspects, the substrate may be sandwiched between the two frames 2 ,3 and held in place by friction without a further fixation system.

The second frame 2 can be beveled at an inner region of the second frame 2 next to the substrate 7. In Fig. 6, a beveling 201 reduces the thickness of the second frame 2 from a first thickness in the outer region of the second frame 2 to a second region at an inner edge of the second frame 2. Whereas the first thickness may be chosen, in view of the other geometrical parameters of the first frame 3, to provide the frame with predetermined mechanical properties, the second thickness and the angle of the beveling 201 may be chosen in view of the geometry and directional characteristics of the deposition source. It is believed that, in particular when employing moving substrates in deposition facilities having multiple deposition sources mounted close to the substrate surface, this beveling may reduce or eliminate any inhomogeneity of the coating on the substrate in the outer regions of the substrate 7 by reducing or eliminating shadowing effects that may occur when the edge portion of the first frame 3 has a too large second thickness.

In Fig. 6, the second frame 2 comprises a recession to receive the first frame 3. Such a geometry can be advantageous to lower the thickness of the combined first 3 and second 2 frames. In addition, it may further simplify the mounting process, as both frames may not move freely in all directions in such configuration. As the thermal expansion of both frames may differ, appropriate gaps 10 may be provided to allow the frames to expand in a well defined manner.

Furthermore, the surface 200 of the second frame 2 exposed to the deposition source may include patterned sections (not shown in Fig. 6). These patterned sections may increase the surface area of the second frame 2 which may enlarge the amount of material that can be deposited onto said sections before a critical thickness for any detachment of particles may is reached. In addition, it is believed that in general a coating may adhere better to a patterned surface. The structured sections can have any suitable shape, in particular a waffle-pattern.

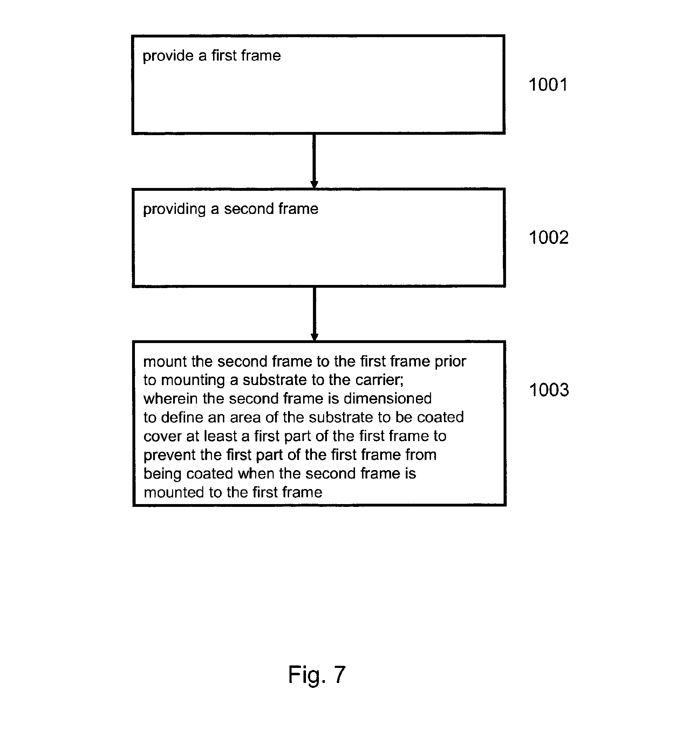

Fig. 7 depicts schematically a method to assemble a carrier comprising the steps of providing a first frame 1001, providing a second frame 1002, mounting the second frame to the first frame prior to mounting a substrate to the carrier 1003, wherein the second frame is dimensioned to define an area of the substrate to be coated, and to cover at least a first part of the first frame to prevent the first part of the first frame from being coated when the second frame is mounted to the first frame.

In preferred methods for assembling the carrier the mounting of the second frame to the first frame is done by using keyhole bolt joints as described above. In such cases, in particular when the keyholes comprise chamfers, the second frame may just be suspended to the first frame by engaging the bolts to the keyholes. By virtue of the chamfers the second frame may be then pulled towards the first frame. The vertical and the horizontal sections of the second frame may be joined before mounting it to the first frame or alternatively after the vertical and horizontal sections of the second frame have been mounted to the first frame.

## Claims

1. Carrier (1) for a substrate to be coated in a vacuum chamber comprising:
a first frame (3) comprising two vertical sections (32) and two horizontal sections (31) being dimensioned to surround the substrate;
a second frame (2) dimensioned
to define an area of the substrate to be coated, and
to cover at least a first part (33) of the first frame (3) to prevent the first part (33) of the first frame (3) from being coated when the second frame (2) is mounted to the first frame (3); and
wherein the second frame (2) is detachably mounted to the first frame (3), and
wherein the vertical sections (32) of the first frame (3) are of a different material than the horizontal sections (31) of the first frame (3) and/or the second frame (2) comprises two vertical sections (22) and two horizontal sections (21) of a different material than the vertical sections (22) of the second frame (2).

2. The carrier of claim 1, wherein the second frame (2) is dimensioned to prevent an edge area of the substrate from being coated.

3. The carrier of claim 1, wherein the horizontal sections (31) of the first frame (3) comprise Aluminum and/or the vertical sections (32) of the first frame (3) comprise Titanium.

4. The carrier of claim 1 or 3, wherein the horizontal sections (21) of the second frame (2) comprise Titanium and/or the vertical sections (22) of the second frame (2) comprise Aluminum.

5. The carrier of any of the claims 1 to 4, wherein the second frame (2) is detachably mounted to the first frame using keyhole bolt joints, wherein the second frame (2) comprises bolts at a side facing the first frame (3), the bolts designed to engage with corresponding keyhole (62) openings in the first frame (3), wherein the keyholes (62) are designed to allow movement of the corresponding bolts in an engaged position.

6. The carrier of claim 5, wherein the keyholes (62) are designed such that the movement of the corresponding bolts in the engaged position is more limited in a first spatial direction, especially in the vertical direction, than in a second spatial direction, especially in the horizontal direction, the first and second spatial directions are both in a plane substantially parallel to the first frame, preferably wherein the keyholes are designed to take a relative movement of the first frame (3) with respect to the second frame (2) caused by thermal expansion when being heated from a first temperature to a second temperature into account, preferably the second temperature is a processing temperature of the vacuum chamber.

7. The carrier of any of the claims 1 to 6, wherein a surface (200) of the second frame (2) which is exposed to coating in the vacuum chamber comprises surface patterned sections, especially waffle-patterned sections.

8. The carrier of claim 7, wherein only the vertical sections (22) of the second frame (2) comprise the surface patterned sections.

9. The carrier of any of the claims 1 to 8, wherein the horizontal sections (31) of the first frame (3) comprise horizontal slots to reduce thermal deformation of the outer parts of the horizontal sections (31).

10. The carrier of any of the claims 1 to 9, further comprising clamping means (8) supported by the first frame (3) and suitable to fix the substrate by clamping against the second frame (2).

11. A method for assembling a carrier according to any of claims 1 to 10, for a substrate to be coated in a vacuum chamber comprising the steps of:
providing a first frame (1001),
providing a second frame (1002),
removably mounting the second frame to the first frame prior to mounting a substrate to the carrier (1003);
wherein the second frame is dimensioned
to define an area of the substrate to be coated, and
to cover at least a first part of the first frame to prevent the first part of the first frame from being coated when the second frame is mounted to the first frame

12. The method of claim 11, wherein the second frame is dimensioned to prevent an edge area of the substrate from being coated.

13. The method of claim 11 or 12, wherein mounting the second frame to the first frame includes using keyhole bolt joints.

14. The method of any of claims 11 to 13, further comprising:
preassembling the second frame before the second frame is mounted to the first frame, wherein reassembling the second frame comprises joining vertical sections and horizontal sections of the second frame.

15. The method of any of claims 11 to 14, wherein removably mounting the second frame to the first frame further comprises:
mounting predeteimined parts of the second frame separately to the first frame, preferably mounting verticals sections and horizontal sections of the second frame separately to the first frame.

## Patentansprüche

1. Träger (1) für ein zu beschichtendes Substrat in einer Vakuumkammer umfassend:
einen ersten Rahmen (3) mit zwei vertikalen Abschnitten (32) und zwei horizontalen Abschnitten (31), derart dimensioniert, dass sie das Substrat umgeben;
einen zweiten Rahmen (2), dimensioniert,
um ein zu beschichtendes Gebiet des Substrates festzulegen, und
wenigstens einen ersten Teil (33) des ersten Rahmens (3) zu bedecken, um zu verhindern, dass der erste Teil (33) des ersten Rahmens (3) beschichtet wird, wenn der zweite Rahmen (2) an dem ersten Rahmen (3) befestigt ist; und
wobei der zweite Rahmen (2) abnehmbar an dem ersten Rahmen (3) befestigt ist, und
wobei die vertikalen Abschnitte (32) das ersten Rahmens (3) aus einem anderen Material als die horizontalen Abschnitte (31) des ersten Rahmens (3) sind und/oder der zweite Rahmen (2) zwei vertikale Abschnitte (22) und zwei horizontale Abschnitte (21) aus einem anderen Material als die vertikalen Abschnitte (22) des zweiten Rahmens (2) umfasst.

2. Der Träger aus Anspruch 1, wobei der zweite Rahmen (2) dimensioniert ist, um zu verhindern, dass ein Kantenbereich des Substrates beschichtet wird.

3. Der Träger aus Anspruch 1, wobei die horizontalen Abschnitte (31) des ersten Rahmens (3) Aluminium umfassen und/oder die vertikalen Abschnitte (32) des ersten Rahmens (3) Titan umfassen.

4. Der Träger aus Anspruch 1 oder 3, wobei die horizontalen Abschnitte (21) des zweiten Rahmens (2) Titan umfassen und/oder die vertikalen Abschnitte (22) des zweiten Rahmens (2) Aluminium umfassen.

5. Der Träger gemäß einer der Ansprüche 1 bis 4, wobei der zweite Rahmen (2) abnehmbar an dem ersten Rahmen befestigt ist mittels Schlüssellochbolzenverbindungen, wobei der zweite Rahmen (2) an einer zu dem ersten Rahmen (3) gerichteten Seite Bolzen umfasst, wobei die Bolzen ausgelegt sind, mit korrespondierenden Schlüsselloch(62)öffnungen in dem ersten Rahmen (3) in Eingriff zu kommen, wobei die Schlüssellöcher (62) ausgelegt sind, eine Bewegung der korrespondierenden Bolzen in eine Eingriffsposition zu erlauben.

6. Der Träger aus Anspruch 5, wobei die Schlüssellöcher (62) derart ausgelegt sind, dass die Bewegung der korrespondierenden Bolzen in die Eingriffsposition mehr in einer ersten Raumrichtung beschränkt ist, insbesondere in der vertikalen Richtung, als in einer zweiten Raumrichtung, insbesondere in der horizontalen Richtung, dass die erste und zweite Raumrichtungen beide in einer Ebene im wesentlichen parallel zu dem ersten Rahmen sind, wobei vorzugsweise die Schlüssellöcher ausgelegt sind, eine Relativbewegung des ersten Rahmens (3) in Bezug auf den zweiten Rahmen (2), verursacht durch die thermische Ausdehnung auf die Erhitzung von einer ersten Temperatur zu einer zweiten Temperatur hin, zu berücksichtigen, wobei die zweite Temperatur vorzugsweise eine Prozesstemperatur der Vakuumkammer ist.

7. Der Träger gemäß einem der Ansprüche 1 bis 6, wobei eine Oberfläche (200) des zweiten Rahmens (2), die der Beschichtung in der Vakuumkammer ausgesetzt ist, oberflächenstrukturierte Abschnitte umfasst, insbesondere Waffel-gemusterte Abschnitte.

8. Der Träger aus Anspruch 7, wobei nur die vertikalen Abschnitte (22) des zweiten Rahmens (2) die oberflächenstrukturierten Abschnitte umfassen.

9. Der Träger gemäß einer der Ansprüche 1 bis 8, wobei die horizontalen Abschnitte (31) des ersten Rahmens (3) horizontale Schlitze umfassen, um die thermische Deformation der äußeren Teile der horizontalen Abschnitte (31) zu reduzieren.

10. Der Träger gemäß einem der Ansprüche 1 bis 9, des Weiteren Klemmittel (8) umfassend, die von dem ersten Rahmen (3) getragen werden, und geeignet sind, dass Substrat zu fixieren, indem es gegen den zweiten Rahmen (2) geklemmt wird.

11. Ein Verfahren zum Zusammensetzen eines Trägers gemäß einem der Ansprüche 1 bis 10 für ein zu beschichtendes Substrat in einer Vakuumkammer mit folgenden Schritten:
zur Verfügung Stellen eines ersten Rahmens (1001),
zur Verfügung Stellen eines zweiten Rahmens (1002),
entfernbar Befestigen des zweiten Rahmens an dem ersten Rahmen vor dem Befestigen eines Substrates an dem Träger (1003);
wobei der zweite Rahmen dimensioniert ist,
um ein zu beschichtendes Gebiet des Substrates festzulegen, und
wenigstens einen ersten Teil des ersten Rahmens zu bedecken, um zu verhindern, dass der erste Teil des ersten Rahmen beschichtet wird, wenn der zweite Rahmen an den ersten Rahmen befestigt ist.

12. Das Verfahren gemäß Anspruch 11, wobei der zweite Rahmen dimensioniert ist, um zu verhindern, dass ein Kantengebiet des Substrates beschichtet wird.

13. Das Verfahren gemäß Anspruch 11 oder 12, wobei Befestigen des zweiten Rahmens an dem ersten Rahmen das Benutzen von Schlüssellochbolzenverbindungen umfasst.

14. Das Verfahren gemäß einem der Ansprüche 11 bis 13, dass weiteren umfassend:
Vormontieren des zweiten Rahmens bevor der zweite Rahmen an dem ersten Rahmen befestigt wird, wobei Vormontieren des zweiten Rahmens Verbinden der vertikalen Abschnitte und horizontalen Abschnitte des zweiten Rahmens umfasst.

15. Das Verfahren gemäß einem der Ansprüche 11 bis 14, wobei entfernbar Befestigen des zweiten Rahmens an dem ersten Rahmen des Weiteren umfasst:
gesondertes Befestigen von vordefinierten Teilen des zweiten Rahmens an dem ersten Rahmen, vorzugsweise gesondertes Befestigen von vertikalen Abschnitten und horizontalen Abschnitten des zweiten Rahmens an dem ersten Rahmen.

## Revendications

1. Support (1) pour un substrat devant être revêtu dans une chambre à vide, comprenant :
un premier cadre (3) comprenant deux sections verticales (32) et deux sections horizontales (31) qui sont dimensionnées de façon à entourer le substrat ;
un deuxième cadre (2) dimensionné
de façon à définir une zone du substrat devant être revêtu, et
à recouvrir au moins une première partie (33) du premier cadre (3) pour empêcher que la première partie (33) du premier cadre (3) soit revêtue lorsque le deuxième cadre (2) est monté sur le premier cadre (3) ; et
dans lequel le deuxième cadre (2) est monté de façon détachable sur le premier cadre (3), et
dans lequel les sections verticales (32) du premier cadre (3) sont d'un matériau différent des sections horizontales (31) du premier cadre (3) et/ou le deuxième cadre (2) comprend deux sections verticales (22) et deux sections horizontales (21) d'un matériau différent des sections verticales (22) du deuxième cadre (2).

2. Le support de la revendication 1, dans lequel le deuxième cadre (2) est dimensionné de façon à empêcher qu'une zone de bordure du substrat soit revêtue.

3. Le support de la revendication 1, dans lequel les sections horizontales (31) du premier cadre (3) comprennent de l'aluminium et/ou les sections verticales (32) du premier cadre (3) comprennent du titane.

4. Le support de la revendication 1 ou 3, dans lequel les sections horizontales (21) du deuxième cadre (2) comprennent du titane et/ou les sections verticales (22) du deuxième cadre (2) comprennent de l'aluminium.

5. Le support de l'une quelconque des revendications 1 à 4, dans lequel le deuxième cadre (2) est monté de façon détachable sur le premier cadre au moyen de raccords à boulons à trous de serrure, dans lequel le deuxième cadre (2) comprend des boulons d'un côté faisant face au premier cadre (3), les boulons étant conçus pour s'engager dans des ouvertures en trou de serrure (62) correspondantes dans le premier cadre (3), les trous de serrure (62) étant conçus pour permettre un mouvement des boulons correspondants dans une position engagée.

6. Le support de la revendication 5, dans lequel les trous de serrure (62) sont conçus de telle façon que le mouvement des boulons correspondants dans la position engagée soit plus limité dans une première direction spatiale, en particulier dans la direction verticale, que dans une deuxième direction spatiale, en particulier dans la direction horizontale, la première et la deuxième direction spatiale étant toutes deux dans un plan sensiblement parallèle au premier cadre, les trous de serrure étant de préférence conçus pour prendre en compte un mouvement relatif du premier cadre (3) par rapport au deuxième cadre (2), causé par dilatation thermique lors d'une chauffe d'une première température à une deuxième température, la deuxième température étant de préférence une température de traitement de la chambre à vide.

7. Le support de l'une quelconque des revendications 1 à 6, dans lequel une surface (200) du deuxième cadre (2) qui est exposée pour le revêtement dans la chambre à vide, comprend des sections à structure de surface, en particulier des sections à structure alvéolaire.

8. Le support de la revendication 7, dans lequel seules les sections verticales (22) du deuxième cadre (2) comprennent les sections à structure de surface.

9. Le support de l'une quelconque des revendications 1 à 8, dans lequel les sections horizontales (31) du premier cadre (3) comprennent des fentes horizontales pour réduire la déformation thermique des parties extérieures des sections horizontales (31).

10. Le support de l'une quelconque des revendications 1 à 9, comprenant en outre des moyens de serrage (8) supportés par le premier cadre (3) et aptes à fixer le substrat par serrage contre le deuxième cadre (2).

11. Procédé d'assemblage d'un support selon l'une quelconque des revendications 1 à 10, pour un substrat devant être revêtu dans une chambre à vide, comprenant les étapes consistant à :
fournir un premier cadre (1001),
fournir un deuxième cadre (1002),
monter de manière amovible le deuxième cadre sur le premier cadre avant de monter un substrat sur le support (1003) ;
dans lequel le deuxième cadre est dimensionné
de façon à définir une zone du substrat devant être revêtu, et
à recouvrir au moins une première partie du premier cadre pour empêcher que la première partie du premier cadre soit revêtue lorsque le deuxième cadre est monté sur le premier cadre.

12. Le procédé de la revendication 11, dans lequel le deuxième cadre est dimensionné pour empêcher qu'une zone de bordure du substrat soit revêtue.

13. Le procédé de la revendication 11 ou 12, dans lequel le montage du deuxième cadre sur le premier cadre inclut l'utilisation de raccords à boulons à trous de serrure.

14. Le procédé de l'une quelconque des revendications 11 à 13, comprenant en outre :
le préassemblage du deuxième cadre avant que le deuxième cadre soit monté sur le premier cadre, le préassemblage du deuxième cadre comprenant l'assemblage de sections verticales et de sections horizontales du deuxième cadre.

15. Le procédé de l'une quelconque des revendications 11 à 14, dans lequel le montage de façon amovible du deuxième cadre sur le premier cadre comprend en outre :
le montage de parties prédéterminées du deuxième cadre séparément sur le premier cadre, de préférence le montage de sections verticales et de sections horizontales du deuxième cadre séparément sur le premier cadre.
